# EUROPEAN PATENT APPLICATION

(11) **EP 1 103 633 A1**
(43) Date of publication of application: **30.05.2001**
(21) Application number: 00870283.9
(22) Date of filing: 28.11.2000
(51) Int. Cl.: C23C 18/54

(54) **Method for copper plating deposition**

(30) Priority: 29.11.1999 EP 99870242
(71) Applicant: INTERUNIVERSITAIRE MICROELEKTRONICA CENTRUM VZW, 3001 Leuven (BE)
(72) Inventor: Palmans, Roger, 3770 Riemst (BE); Lantasov, Yuri, 3001 Leuven (BE)
(74) Representative: Van Malderen, Joelle

(57) **Abstract**

The present invention describes a method for copper deposition on a substrate having a barrier layer wherein a substrate (2) and an activator (1) are immersed in a copper plating bath in order to contact each other for a predetermined period.

## Description

### Field of the invention

The present invention is related to metal deposition processes as used for instance for the formation of conductive patterns connecting active or passive devices as well as integrated circuits. In particular, such conductive patterns can be formed at least partly by means of a plating deposition technique.

### Background of the invention

Electroless deposition has been used in the electronic packaging and the printed circuit board industry as a very efficient and cheap deposition technique for the production of thick films and for via-hole plating. To incorporate its use into the microelectronics industry, the reliability and quality of submicron lines and via's generated by electroless deposition is a key issue.

The electroless deposition method involves the formation of a thin film of material from a plating bath without external electric current. The deposition is due to an electrochemical reaction between the metal ions, a reducing agent, a complexing agent, and pH adjusters on a catalytic surface. The deposition occurs by simultaneous oxidation-reduction reactions between two half reactions involving electron generation and electron reduction. The metal cations in the solution accept electrons at the deposition surface, get reduced, and are deposited as metal. A catalytic surface usually consists of either: 1) a surface which has been activated for instance with palladium nuclei, 2) a thin evaporated or sputtered seed of a noble metal like gold, platinum or palladium, or 3) an insulator (or non-catalytic semiconductor or metal) which is sensitised by coating it with a thin metal that can be less than a mono-layer. Once a thin layer of metal has been deposited onto the seed layer or sensitised surface, electroless deposition continues autocatalytically, since the metallic film is also a good catalyst for electroless growth.

For trench or via-hole plating, European Patent EP1020543 has proposed an original copper electroless plating bath fulfilling the stringent requirements for copper plating in sub-micro high aspect ratio features onto typical Cu diffusion barrier layer such as Ti, TiN, Ta, TaN, WNₓ, Ni, Ni-alloy and Co barrier-layers.

However, in order to obtain good quality electroless copper deposition on these barrier layers, first an activation step with deposition of palladium nuclei onto the barrier layer is required.

Moreover, the critical step for obtaining a catalytic surface to initiate copper deposition is still present.

Document WO 99/10916 claiming the priority of document US 6,054,173 and related patents US 6,054,172 and US 6,129,989 disclose methods for eletroless deposition of copper on a titanium-containing surface of a substrate. One method for depositing copper on a substrate includes providing the substrate having a titanium-containing surface and forming a patterned catalyst material on the substrate, such that the titanium-containing surface is exposed in selected regions. Preferably, the catalyst material is selected from the group consisting of silicon, aluminium and chromium. The titanium-containing surface can be titanium or titanium nitride. Copper is then deposited on the exposed regions of the titanium-containing surface from an electroless solution preferably containing a source of copper and a reducing agent. The pH of said electroless solution is about 9 to 12.

### Aims of the invention

One aim of the present invention is to initiate copper deposition from a plating solution directly on said barrier layers without requiring the above mentioned palladium activation step.

Another aim of the invention is to provide a new method for a conform and high quality copper deposition on barrier layers.

### Summary of the invention

The invention discloses a new method for copper deposition on a substrate having a barrier layer characterized in that
- a substrate is immersed in a copper plating bath, and that
- an activator is also immersed in said copper bath and
- direct contact is performed between said activator and said substrate for a predetermined period.

Preferably, the substrate is cleaned in a diluted HF solution, typically a 0.5 w%-10 w% HF solution, before it is immersed in the copper plating bath, in order to remove any native oxide.

A physical contact is necessary between the activator and the substrate for the copper deposition to occur.

The copper plating bath can be either a standard electroless plating bath or a plating bath without reducing agent.

The activator is preferably a contact metal which comprises at least an element selected from the group comprising Al, Zn and Pd.

Said activators may act according to two different mechanisms. When the activator is Al or Zn, it acts according to a first mechanism, wherein the activator has to be dissolved in the copper plating bath for copper deposition to occur on the substrate. When the activator is Pd, such a dissolution is not necessary. Pd acts according to a second mechanism, namely a self-limiting mechanism.

It has been established that Si and Cr can not work as activators.

The barrier layer is preferably selected from the group comprising a Ti layer, a TiN layer, a WNₓ layer, Ta, TaN, Ni and Ni-alloy barrier-layers, a Co layer and Co-alloy barrier layers.

The copper plating bath preferably comprises at least:
- a source of Cu (II) ions
- a complexing agent to keep the Cu(II) ions in solution at high pH values
- an additive to adjust the pH of said bath.

Preferably, said complexing agent is diethyl-tartrate.

This copper plating bath can also comprise a reducing agent, preferably formaldehyde or hypophosphite.

The pH of the copper plating bath is comprised between 12.0 and 13.5. It has been shown that no copper deposition may occur if the pH of the copper plating bath is below 12.0.

The predetermined time period for direct contact between the two samples is preferably comprised between 10 sec. and 30 min.

The activator may have a determined shape. It can be in the form of a clamping ring or metal contacts placed on the wafer edge in contact with the barrier layer.

The method according to the present invention is preferably used for contact plated copper deposition on an opening (trench or via) in a substrate having a blanket barrier layer.

### Short description of the drawings

Figure 1 is describing a basic experiment involved in the first aspect of the present invention.

Figure 2 shows SEM pictures of Cu deposition on TiN by Al contact plating.

Figure 3 shows a device dedicated to an industrial process for contact plated copper deposition, according to one preferred embodiment of the invention.

Figure 4 represents the several steps of a process for contact plated copper deposition according to another preferred embodiment of the invention.

Figure 5 represents typical sheet resistance mappings over 6 inch wafers obtained with the copper deposition process according to the present invention.

Figure 6a represents a TEM picture of Cu deposition on a TiN covered wafer using a copper plating bath with formaldehyde as reducing agent.

Figure 6b represents a TEM picture of Cu deposition on a TiN covered wafer using a copper plating bath without formaldehyde as reducing agent.

### Description of several embodiments of the invention

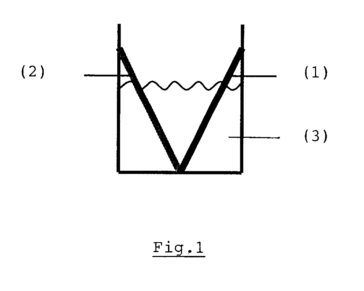

Figure 1 is describing a basic embodiment wherein a barrier layer on a substrate (2), hereafter referred to as sample 2, has been brought into contact with an Al-sample (1), hereafter referred to as sample 1 and is immersed in a bath (3) being either a conventional electroless plating bath or a plating bath without a reducing agent. It is observed that Cu is deposited on the barrier layer if a contact occurs between the two samples. In the absence of contact between the two samples, no copper is deposited on the barrier layer. Also, it is observed that addition of Al(III) ions to the plating solution does not lead to copper deposition when no aluminium contact exists. Several other experiments have been performed based on the same experiment wherein :
(i) sample 1 is an Al-sample which can be:
   - Al alloy covered wafer: Pieces of wafer HLI (400 nm LLS Al-0.5%Cu on SiO2/Si)
   - or any aluminium substrate that can be brought into contact with the barrier layer (strips, foils, ...);
(ii) sample 2 is a wafer having on its top a barrier layer which can be :
   - TiN: Pieces of wafers TR9800923 (15 nm / 60 nm IMP Endura Ti/TiN on SiO2/Si). These samples are cleaned previously in 2,5% HF for 1 min (or in 5% HF for 30 sec)
   - WNₓ: Pieces of wafer TR9800482 #05 (60 nm WNₓ on SiO₂/Si)
   - Co: Pieces of wafer TMPA #6 (60 nm Co on SiO₂/Si)
   - TaN: Pieces of wafer CU9850 #6 (60 nm Endura TaN on SiO₂/Si)
   - or Ta: Pieces of wafer TR9801029#24 (60 nm Endura Ta on SiO₂/Si) .

In a first embodiment of the present invention, the plating solution contains formaldehyde as reducing agent. The pH of solution has to be above 12.0.

It is observed that deposition occurs when the barrier layer of sample 2 is TiN, WNₓ or Co. No deposition is observed in the case of TaN nor Ta because the cleaning time with HF solution was too short. However, for longer cleaning times or with more concentrated HF cleaning solutions, copper deposition occurs with TaN or Ta as barrier layer.
The results are summarised in Table 1.

Based on the same experiment as described in figure 1, new experiments have been performed with the same solution but without formaldehyde and having a pH above 12.5 and wherein:
(i) sample 1 is:
   - Al foil with a thickness of 0.32 mm and a width of 30 mm
   - or an Al-covered wafer
(ii) the barrier layer on sample 2 is:
   - TiN: Pieces of wafers TR9801064 #23 and CU99119 #3,4 (ARC Encura Ti/TiN on SiO₂/Si). Samples are cleaned previously in 2,5% HF for 1 min (or in 5% HF for 30 sec).
   - WNₓ: wafer TR9800482 #02 (60 nm WNₓ on SiO₂/Si).
   - Co: Pieces of wafer TMPA #6, wafer TMPA #5 (60 nm Co on SiO₂/Si) .
   - TaN: Pieces of wafer CU9850 #6 (60 nm Endura TaN on SiO₂/Si) .
   - or Ta: Pieces of wafer TR9801029 #24 (60 nm Endura Ta on SiO₂/Si).
   The results are summarised in Table 2 for TiN samples only.

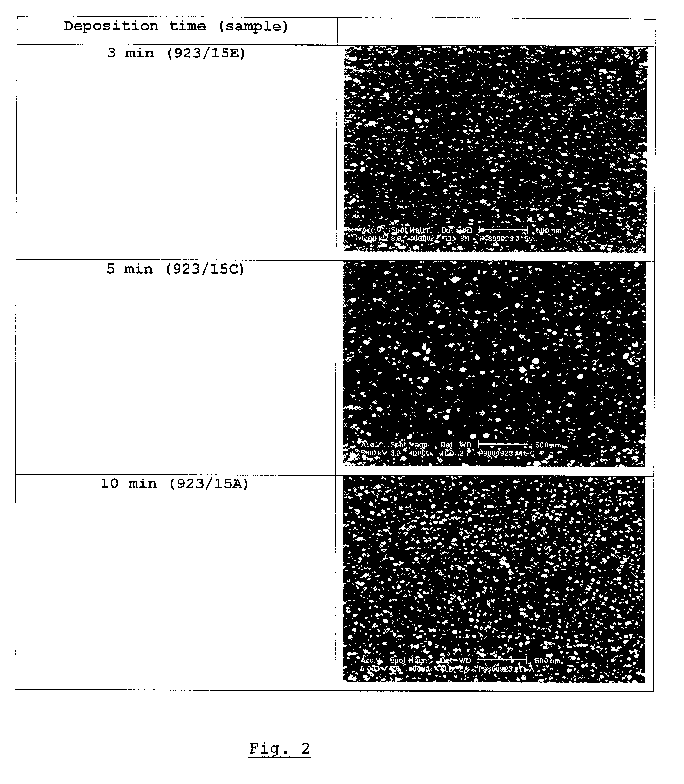

SEM pictures of Cu deposition on TiN by Al contact plating and corresponding to this experiment are presented on figure 2.

Other embodiments similar to those described in figure 1 have been undertaken with a conventional sodium hypophosphite electroless plating bath. In this case the pH is above 12.5. In these experiments, sample 1 is an Al sample, sample 2 has a TiN barrier layer.

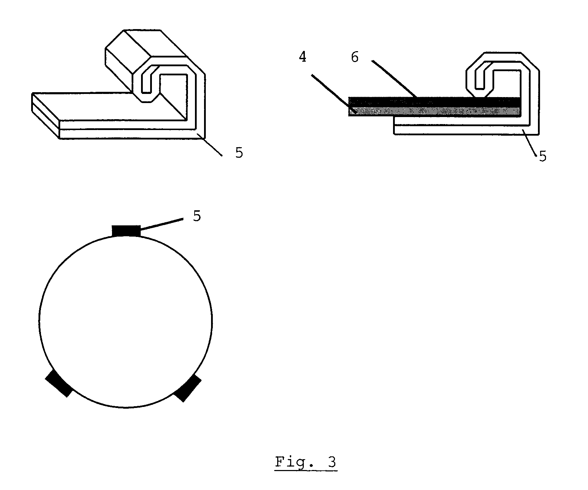

In order to have a best mode embodiment it is suggested to perform the Al-sample in the form of an Al-clamping holder which would clamp the wafer having the barrier layer. Figure 3 is showing such a device used in one preferred embodiment of the present invention that comprises a wafer (4) and 3 Al holders (5). The wafer (4) is typically a Si/SiO2 wafer having a Ti, TiN, Ta, TaN, WNₓ, Ni, Ni-alloy or Co barrier-layer (6). The Al holders (5) are made from Al foil and have the shape of clamping holders. In this experiment, each Al holder has a surface area of (130x30 + 20x130x0.32 + 2x30x0.32) mm².

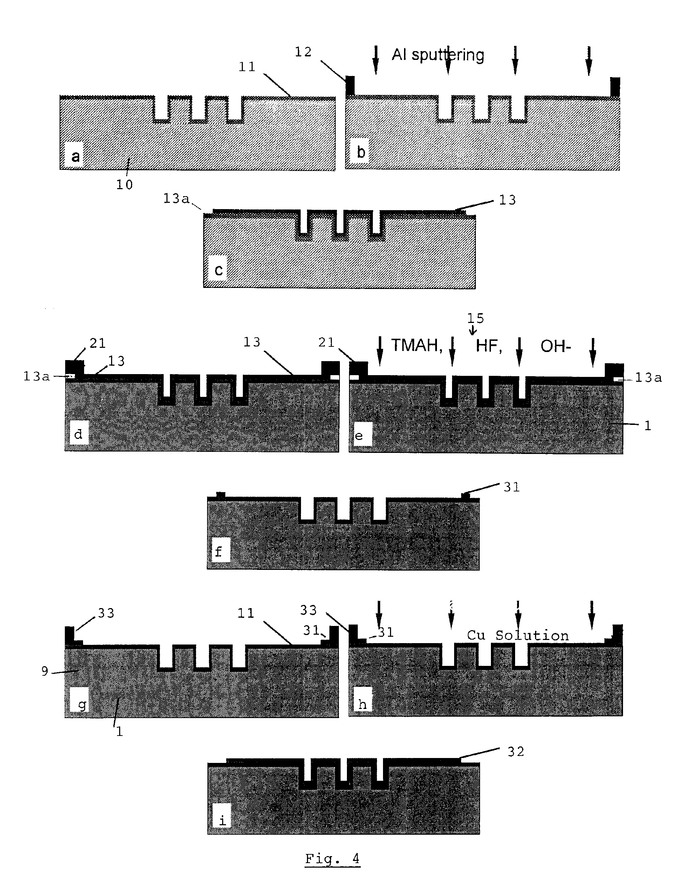

Another best mode of using the method according to the present invention is described in Figure 4, wherein the aluminium ring is formed directly on the barrier layer surface during processing. This best mode embodiment consists of the following steps:
(a) deposition of a barrier layer (11) typically Ti, TiN, Co, Ta, TaN, Ni, Ni alloy or WNₓ on a wafer (10),
(b) fixing a first clamping ring (12) on the top surface of said barrier layer and Al sputtering on said wafer,
(c) removing the clamping ring (12) from the wafer, so that an area (13a) on the barrier layer is not covered by the Al layer (13),
(d) fixation of a second clamping ring (21) covering the whole zone (13a) and partially the A1 layer (13) on the top surface of the wafer (1),
(e) etching of Al in central part (15) of the wafer (1) in a plating tool by either hydroxide solution (NaOH, Tetramethylammonium hydroxide (TMAH), ...) or by an acidic solution (HF, HCl, ...),
(f) after the Al layer has disappeared, said second clamping ring (21) is removed from the wafer, so that only a small portion in the form of a ring of Al still remains directly in contact with the barrier layer (11) on the wafer (1).
(g) A third clamping ring (33) is fixed on one extremity of the wafer on the top surface so that the Al contact is exposed to the plating solution.
(h) Cu plating is initiated on the exposed barrier layer (11) due to dissolution of the Al ring (31).
(i) Finally the third clamping ring (33) is removed and a wafer (1) having a barrier layer (11) covered with a Cu layer (32) except on its extremities is obtained.

The Al sputtering in step (b) can also be done in a tool without a clamping ring on said wafer.

Experiments have been performed to check copper deposition on full wafers according to one preferred embodiment of the present invention (Table 3). In these experiments, sample 1 is an Al holder or an Al ring and sample 2 a Co, a WNₓ or a TiN covered wafer. The solution is a copper plating solution without formaldehyde and having a pH above 12.5.

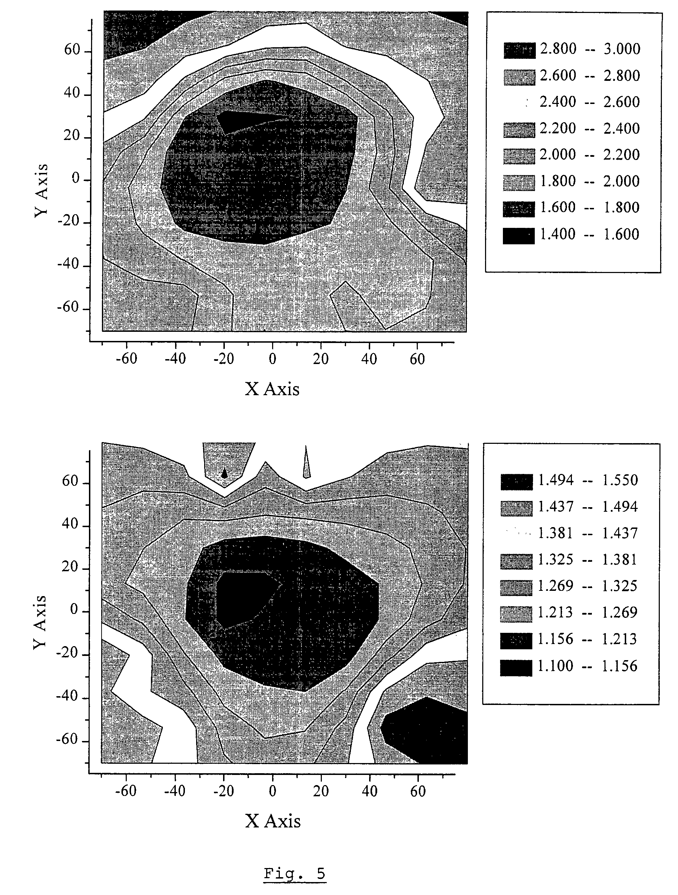

Sheet resistance mappings measured for these wafers are presented in figure 5.

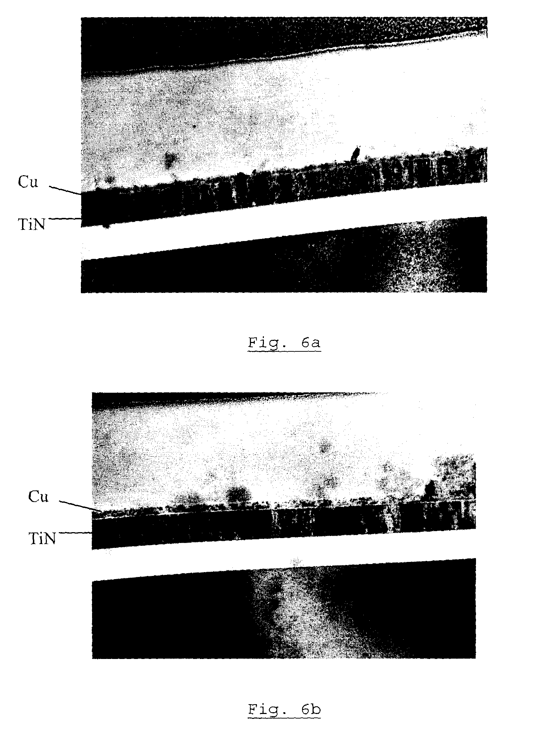

Moreover, two distinct experiments for copper deposition on TiN covered wafers according to another preferred embodiment of the invention have been performed, both using the same copper deposition time, but the first one using a copper plating bath with formaldehyde at pH = 12.42, while the second using a copper plating bath without formaldehyde at pH = 13.0. These two experiments lead to copper covered wafers with different deposition rates: the copper covered wafer has a resistance of 1.97 Ω / sq. and a thickness of 24.4 nm in the first experiment and the copper covered wafer has a resistance of 3.815 Ω / sq. and a thickness of 18.7 nm. TEM pictures illustrating these results are presented in figure 6a and figure 6b, for the first and the second experiments respectively.

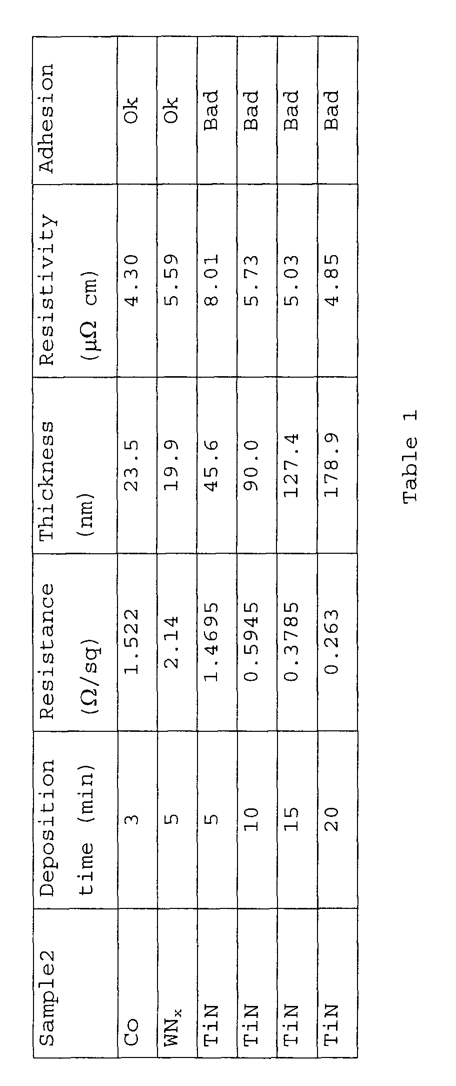

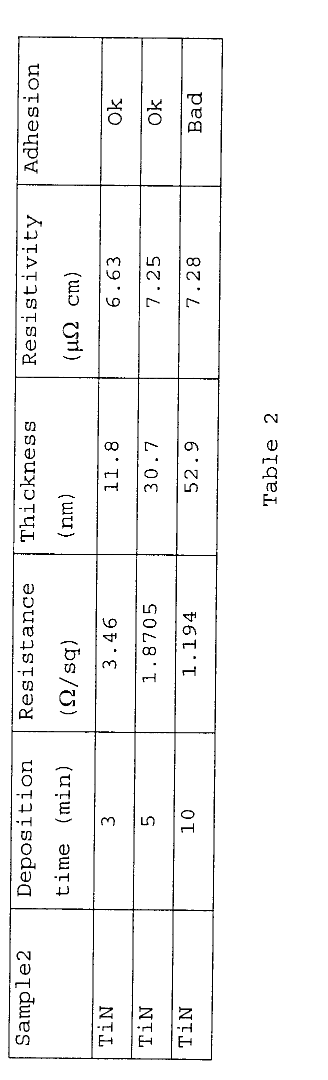

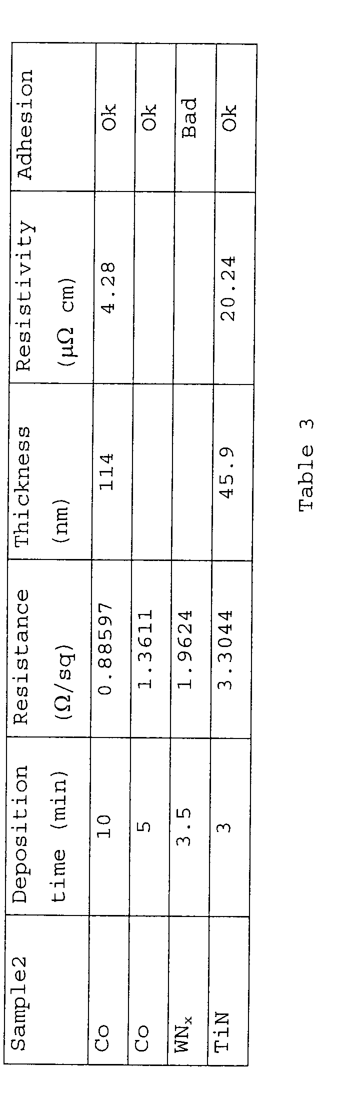

## Claims

1. A plating method for copper deposition on a substrate (2) having a barrier layer characterized in that
- a substrate is immersed in a copper plating bath, and
- an activator (1) is also immersed in said copper plating bath and
- a direct contact is performed between said activator and said substrate for a predetermined period.

2. Method according to claim 1, characterized in that said activator is a contact metal which comprises at least an element selected from the group comprising Al, Zn and Pd.

3. Method according to claim 1, characterized in that said barrier layer is selected from the group comprising a Ti layer, a TiN layer, a WNₓ layer, Ta layer, TaN layer, Ni layer, Ni-alloy layer, a Co layer, and a Co-alloy barrier layer.

4. Method according to claim 1, characterized in that said copper plating bath comprises at least:
- a source of Cu (II) ions
- a complexing agent to keep Cu(II) ions in solution at high pH
- an additive to adjust the pH of said bath.

5. Method according to claim 4, characterized in that said copper plating bath is a copper bath without reducing agent.

6. Method according to claim 4 or 5, characterized in that said complexing agent is diethyl-tartrate.

7. Method according to any one of the preceding claims, characterized in that said substrate is cleaned in a diluted HF solution, typically a 0.5 w%-10 w% HF solution, before it is immersed in the copper plating bath, in order to remove any native oxide.

8. Method according to any one of the preceding claims 4 to 7, characterized in that said copper plating bath has a pH comprised between 12.0 and 13.5.

9. Method according to claim 1, characterized in that said predetermined time period for direct contact between said substrate (2) and said activator (1) is comprised between 10 sec. and 30 min.

10. Method according to claim 1 or 2, characterized in that the activator (1) has a determined shape.

11. Method according to claim 10, characterized in that said determined shape of said activator (1) is a clamping holder (5).

12. Method according to claim 11, characterized in that said determined shape of said activator (1) is a wafer-based contact metal device (31).

13. Use of the method according to any one of the preceding claims for copper deposition on a trench or a via in a substrate having a blanket barrier layer.

14. A solution used to perform the method according to any one of the preceding claims for copper deposition, characterized in that it contains at least:
- a source copper Cu (II) ions
- a complexing agent to keep Cu(II) ions in solution at high pH
- an additive to adjust the pH of said bath between 12.0 and 13.5.

15. Solution according to claim 14, characterized in that the complexing agent is diethyl-tartrate.

16. A device for copper deposition, characterized in that it contains means for performing the method according to any of the preceding claims 1-14.
